Europäisches Patentamt

European Patent Office

Office européen des brevets

(19)

(11) **EP 0 719 015 A2**

(12) **EUROPÄISCHE PATENTANMELDUNG**

(43) Veröffentlichungstag:
26.06.1996 Patentblatt 1996/26

(51) Int. Cl.$^6$: **H04L 27/227**

(21) Anmeldenummer: 95114845.1

(22) Anmeldetag: 21.09.1995

(84) Benannte Vertragsstaaten:
**DE FR GB IT SE**

(30) Priorität: **22.12.1994 DE 4445986**

(71) Anmelder: **ROBERT BOSCH GMBH
70442 Stuttgart (DE)**

(72) Erfinder: **Alberty, Thomas, Dipl.-Ing.
D-71522 Backnang (DE)**

(54) **Frequenzdetektor zur Trägerfrequenzsynchronisation**

(57) Frequenzdetektor zur Trägerfrequenzsynchronisation in Empfängern für digitale Datenübertragung, wobei dem Frequenzdetektor In-Phase-Komponente und Quadratur-Komponente des demodulierten Empfangssignal eingegeben wird, in welchem die Signalterme der doppelten Frequenz unterdrückt sind und welche aus dem Produkt des Empfangssignals mit dem Signal des spannungsgesteuerten Oszillators (VCO) der Frequenzregelschaltung entstanden sind und wobei das Ausgangssignal des Frequenzdetektors als Steuersignal uf für den VCO verwendet wird, wobei Kaskaden von komplexen Bandpässen mit reellen oder komplexen Vorentzerrern (VE) vorgesehen sind, durch welche der Realteil x und der Imaginärteil y des demodulierten Eingangssignals jeweils vor der Bandpaßfilterung vorentzerrt werden, und wobei eine Verknüpfungsschaltung vorgesehen ist, mittels der die Ausgangssignale der Kaskaden zu dem Steuersignal uf verknüpft werden, in dem durch Quadrieren oder Multiplizieren der Ausgangssignale Maße für die Leistung ermittelt werden, die anschließend voneinander subtrahiert werden und so das Steuersignal uf ergeben, dadurch gekennzeichnet, daß mindestens zwei Kaskaden aus je einem Vorverzerrer (VE) und einem Bandpaß vorgesehen sind, deren Mittenfrequenzen jeweils unterschiedliche Betragswerte aufweisen und im Frequenzbereich der einen Nyquistflanke des Leistungsdichtespektrums des demodulierten Empfangsignals liegen. Einsatz insbesondere bei Mobilfunkanlagen, dabei Verbesserung der Trägersynchronisation insbesondere mit Patternjitter-Unterdrückung bei Offset-Modulation.

FIG. 2

EP 0 719 015 A2

## Beschreibung

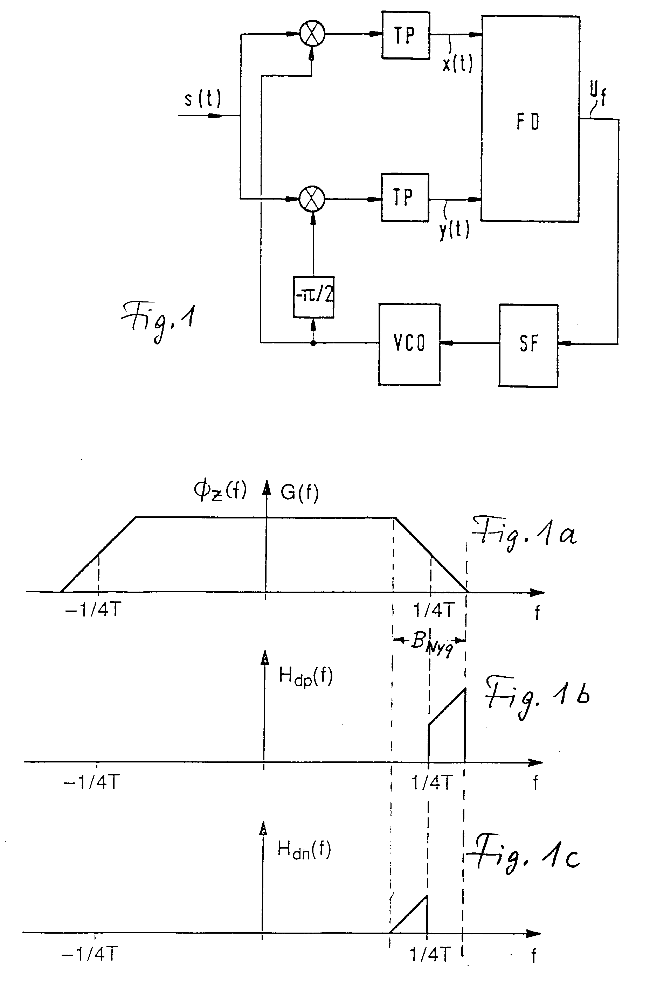

Die Erfindung bezieht sich auf einen Frequenzdetektor gemäß Oberbegriff des Anspruches 1. Solche Frequenzdetektoren (Figur 1) sind bekannt, beispielsweise durch die deutsche Patentschrift 37 07 762.

Bei der Übertragung von Datensignalen ist in vielen Fällen die Korrektur der Trägerfrequenz im Empfänger erforderlich, beispielsweise wenn eine Differenzdemodulation erfolgt. Aber auch beim kohärenten Empfänger, bei welchem die Korrektur der Trägerfrequenz im laufenden Betrieb durch eine Phasenregelschleife (PLL) erfolgt, ist eine weitere Korrektur der Trägerfrequenz erforderlich, um die Anfangssynchronisation der Phasenregeischleife zu beschleunigen, bzw. überhaupt erst zu ermöglichen. In diesen Fällen wird im allgemeinen eine Frequenzregelschleife (AFC) verwendet. Eine wesentliche Komponente dieser Frequenzregelschleife ist der Frequenzfehlerdetektor oder kurz Frequenzdetektor, welcher ein Maß für den momentan vorhandenen Frequenzfehler liefert. Das oben erwähnte Patent beschreibt einen solchen Frequenzdetektor. Wichtig ist hierbei die sogenannte Patternjitterfreiheit, was bedeutet, daß das Ausgangssignal des Frequenzdetektors bei eingeschwungenem Regelkreis unabhängig von dem übertragenen Datenmuster ist.

Die Bedingungen für die Patternjitterfreiheit eines solchen Frequenzfehlerdetektors sind in dem Aufsatz von Alberty und Hespelt "A New Pattern Jitter Free Frequency Error Detector", IEEE COM-37, Nr. 2, Februar 1989, Seiten 159 - 163 beschrieben.

Der Frequenzdetektor, welcher durch das oben erwähnte Patent beschrieben ist, ermöglicht zwar eine Synchronisation auch bei sehr großem Frequenzoffset, ist aufwandsarm realisiert und erreicht auch, daß bei jeder Art von mehrphasiger PSK-Modulation bzw. mehrstufiger Quadratur-Amplituden-Modulation (M-QAM) der Patternjitter vollständig unterdrückt wird, er erwirkt jedoch keine Patternjitterfreiheit bei Offset-Modulationen.

Der vorliegenden Erfindung lag deshalb die Aufgabe zugrunde, einen Frequenzdetektor der eingangs genannten Art anzugeben, welcher bei Offset-Modulationen den Patternjitter vollständig unterdrückt. Weiterhin soll dieser Frequenzdetektor in aufwandsarmer Weise realisiert sein.

Diese Aufgabe wird gelöst durch die Merkmales des Anspruches 1. Vorteilhafte Ausgestaltungen der Erfindung ergeben sich durch die Unteransprüche.

Der erfindungsgemäße Frequenzdetektor ermöglicht eine vollständige Unterdrückung des Patternjitters bei Offset-Modulationen. Er ermöglicht eine Synchronisation auch bei sehr großem Frequenzoffset und ist in aufwandsarmer Weise realisiert.

Die grundlegende Idee der Erfindung liegt in der Erkenntnis, daß man Patternjitterfreiheit für Offset-Modulationen dann erzielen kann, wenn mindestens zwei Kaskaden von Vorentzerrern und Bandpässen bezüglich Mittenfrequenz und Durchlaßbandbreite so gewählt werden, daß sie das Empfangssignal im Bereich nur einer Nyquistflanke in geeigneter Weise auswerten. Selbstverständlich kann das Empfangssignal an der anderen Nyquistflanke in der selben Weise ausgewertet werden, so daß man bei Addition beider Steuersignale eine erhöhte Empfindlichkeit und damit eine erhöhte Regelwirksamkeit erreichen kann.

Es folgt nun die Beschreibung der Erfindung anhand der Figuren.

Die Figur 1 zeigt das Prinzip einer Frequenzregelschaltung und die Figuren 1a, 1b und 1c Frequenspektren.

In Figur 2 und 3 sind Anordnungen für zwei Ausgangsbeispiele für den erfindungsgemäßen Frequenzdetektor wiedergegeben. Schließlich zeigen die Figuren 2a und 3a der Vollständigkeit halber die an sich bekannte Verknüpfungsschaltung für die Kaskadenausgangssignale.

In Figur 1 ist das bekannte Prinzip einer Frequenzregelschleife gezeichnet. Das Ausgangssignal eines spannungsgesteuerten Oszillators VCO wird mit dem eingangsseitigen Empfangssignal s(t) einmal direkt oder zum anderen um $\pi/2$ phasenverschoben multipliziert, über Tiefpässe TP gefiltert, wobei die Produktanteile mit der Summenfrequenz unterdrückt und die gefilterten Signale x(t) und y(t) einem Frequenzdetektor FD eingegeben werden, welcher eine Steuerschaltung uf zur Ansteuerung VCO über ein Schleifenfilter SF erzeugt. Die Steuerspannung uf ist ein Maß für den Frequenzoffset, welcher mittels dieser Regelschleife auf Null geregelt werden soll.

In Figur 1a ist nun ein Frequenzspektrum gezeigt, nämlich das Leistungsdichtespektrum des demodulierten Empfangssignals für einen Frequenzoffset von Null. Es entspricht der Sendefiltercharakteristik G(f). Die Figuren 1b und 1c zeigen nun die spektralen Lagen für ein Ausführungsbeispiel des erfindungsgemäßen Frequenzdetektors mit zwei Kaskaden an der oberen Nyquistflanke. Beide Kaskaden weisen eine Bandbreite von der halben Flankenbreite der Nyquistflanke $B_{Ny}$ auf und sind symmetrisch zur Nyquistfrequenz von $f_{Nyq} = 1/4\,T$ angeordnet. T ist die ymboltaktlänge. Die Durchlaßcharakteristik $H_{dp}$ bzw. $H_{dn}$ sind beispielsweise jeweils invers zur Nyquistflanke und weisen eine Dämpfungscharakteristik auf, so daß beide Kaskaden bei einem Frequenzoffset von Null gleiche Ausgangssignalamplituden und damit gleiche Leistung erzeugen. Der Nyquistfrequenzwert gemäß der Figuren 1a bis 1c ist der für die Offsetmodulation QPSK übliche Wert, selbstverständlich kann der erfindungsgemäße Frequenzdetektor auch für normale QPSK-Modulation oder andere mehrphasigen QPSK-Modulationen bzw. mehrstufigen Quadratur-Amplituden-Modulationen (M-QAM) eingesetzt werden, wobei andere Werte für die Nyquistfrequenz, beispielsweise für normale QPSK $f_{Nyq} = 1/2\,T$, verwendet werden können.

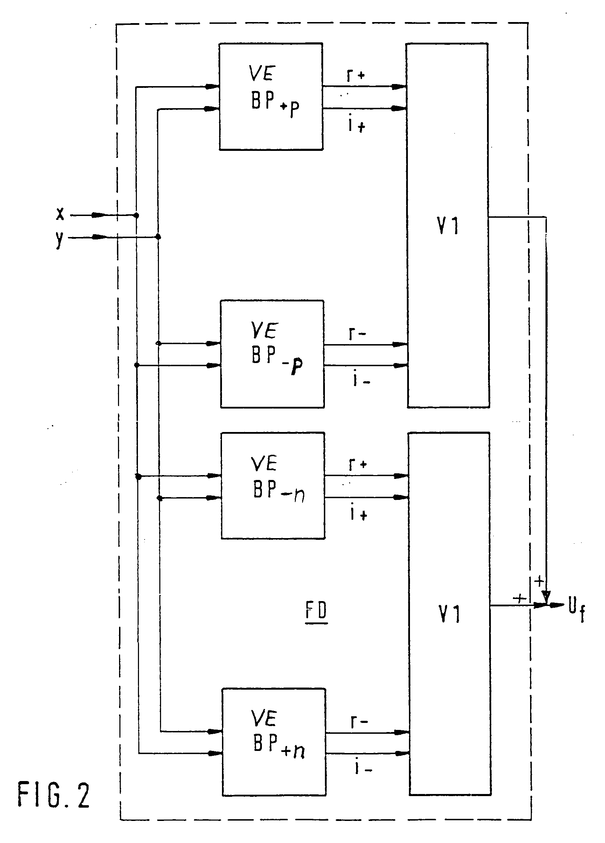

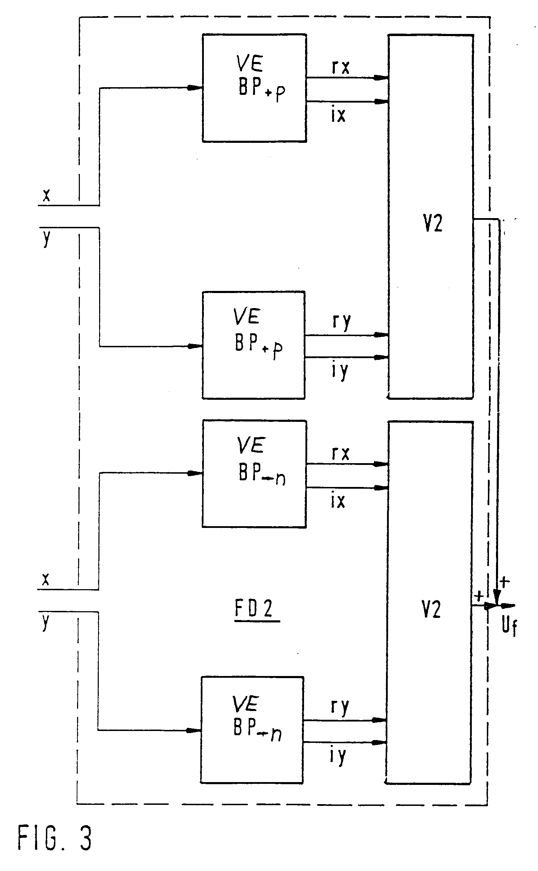

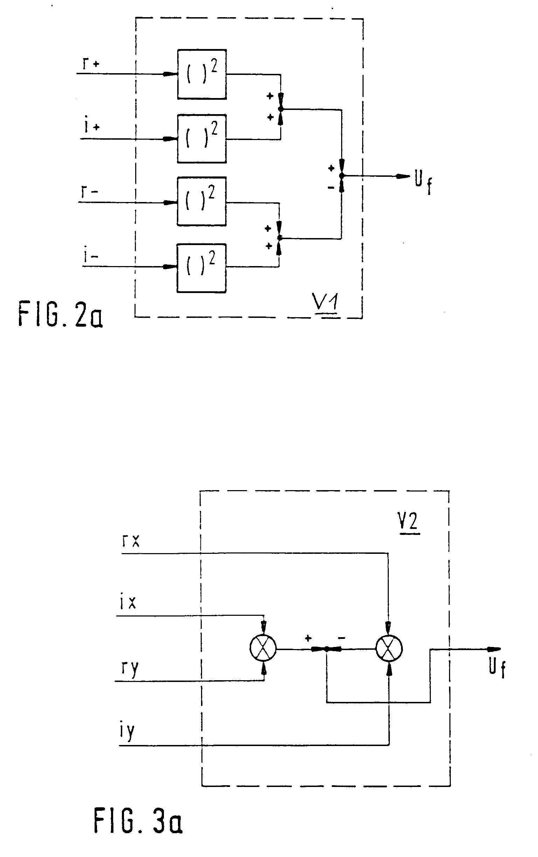

Figur 2 zeigt einen erfindungsgemäßen Frequenzdetektor mit jeweils zwei Kaskaden für jede Nyquistflanke. Jede Kaskade besteht hier aus den komplexen Vorentzerrern VE und Bandpässen BP. Die Blöcke +P und + N sind entsprechend der Figur 1b bzw. 1c an der oberen Nyquistflanke und die Blöcke -P und -N gespiegelt zur Null-Frequenz-Achse an der unteren Nyquistflanke angeordnet. Die Verknüpfungsschaltungen V1 fassen nun die beiden Ausgangssignalpaare +P, -P bzw. +N, -N mittels einer Leistungsdifferenzschaltung zusammen, d.h. nach der Quadrierung von jeweils Real- und Imaginärteil eines jeden komplexen Ausgangssignals der einzelnen Kaskaden werden die Gesamtleistungen von 2 Kaskaden voneinander subtrahiert.

Die Figur 2 zeigt eine Verknüpfung, die eine umgewandelte Anordnung darstellt, welche nun nicht ganz der Anordnung P bzw. N nach Figur 1b bzw. 1c entspricht, sondern hier wurden die Ausgangssignale der Kaskaden miteinander verknüpft, deren Durchlaßbereiche an der Null-Frequenz gespiegelt sind. Ausgehend von der Figur 2 und mit der Kenntnis, daß ein reelles Eingangssignal, das in die Kaskaden der reellen positiven Nyquistflanke eingespeist wird, dasselbe bewirkt wie die beiden Komponenten Realteil und Imaginärteil eines komplexen Eingangssignals in die einander entsprechenden Kaskaden der positiven und negativen Nyquistflanke, kommt man zu der vereinfachten Anordnung der Figur 3. Hier entfallen also die Kaskaden für die negative Nyquistflanke, und die Kaskadeneingänge, sprich Vorentzerrer der verbleibenden Kaskaden an der positiven Nyquistfrequenz sind um die Hälfte weniger aufwendig, da die beiden Eingangsfilterblöcke des Vorentzerrers jeweils bei den einzelnen Kaskaden wegfallen. Der weitere Vorteil ist der, daß zwei identische Kaskaden in jedem Paar realisiert werden können. Die komplexen Ausgangssignale werden nun jeweils mittels eines Verknüpfers V2 ebenfalls mit Leistungsdifferenzbildung verknüpft. Diese Verknüpfung wird nach der Beziehung uf = ix · ry - rx · iy realisiert; sie ist in der Figur 3a als Schaltung abgebildet. Ergänzend dazu zeigt die Figur 2a die Verknüpfungsschaltung V1, wie sie beispielsweise bei dem Frequenzdetektor nach Figur 1b und 1c bzw. nach Figur 2 Verwendung findet. Dort wird die Quadrierung mit r² und i² durchgeführt, der eine Addition der zusammengehörigen Signale folgt, welche schließlich voneinander abgezogen werden und letztendlich das Steuersignal uf bilden.

**Patentansprüche**

1. Frequenzdetektor zur Trägerfrequenzsynchronisation in Empfängern für digitale Datenübertragung, wobei dem Frequenzdetektor In-Phase-Komponente und Quadratur-Komponente des demodulierten Empfangssignal eingegeben wird, in welchem die Signalterme der doppelten Frequenz unterdrückt sind und welche aus dem Produkt des Empfangssignals mit dem Signal des spannungsgesteuerten Oszillators (VCO) der Frequenzregelschaltung entstanden sind und wobei das Ausgangssignal des Frequenzdetektors als Steuersignal uf für den VCO verwendet wird, wobei Kaskaden von komplexen Bandpässen mit reellen oder komplexen Vorentzerrern (VE) vorgesehen sind, durch welche der Realteil x und der Imaginärteil y des demodulierten Eingangssignals jeweils vor der Bandpaßfilterung vorentzerrt werden, und wobei eine Verknüpfungsschaltung vorgesehen ist, mittels der die Ausgangssignale der Kaskaden zu dem Steuersignal uf verknüpft werden, in dem durch Quadrieren oder Multiplizieren der Ausgangssignale Maße für die Leistung ermittelt werden, die anschließend voneinander subtrahiert werden und so das Steuersignal uf ergeben, dadurch gekennzeichnet, daß mindestens zwei Kaskaden aus je einem Vorverzerrer (VE) und einem Bandpaß vorgesehen sind, deren Mittenfrequenzen jeweils unterschiedliche Betragswerte aufweisen und im Frequenzbereich der einen Nyquistflanke des Leistungsdichtespektrums des demodulierten Empfangssignals liegen.

2. Frequenzdetektor nach Anspruch 1, dadurch gekennzeichnet, daß für mindestens zwei Kaskaden aus je einem Vorverzerrer (VE) und einem Bandpaß vorgesehen sind, deren Mittenfrequenzen unterschiedliche Betragswerte aufweisen und im Frequenzbereich der anderen Nyquistflanke des Leistungsdichtespektrums des demodulierten Empfangssignals liegen.

3. Frequenzdetektor nach Anspruch 1 oder 2, dadurch gekennzeichnet, daß die Frequenzdurchlaßbereiche der einzelnen Kaskaden rasterförmig angeordnet sind.

4. Frequenzdetektor nach einem der vorherigen Ansprüche, dadurch gekennzeichnet, daß die Frequenzdurchlaßbereiche der einzelnen Kaskaden lückenlos sich aneinanderreihen.

5. Frequenzdetektor nach einem der Ansprüche 1 bis 3, dadurch gekennzeichnet, daß zwischen den einzelnen Frequenzdurchlaßbereichen der einzelnen Kaskaden Lücken eingefügt sind.

6. Frequenzdetektor nach einem der vorhergehenden Ansprüche, dadurch gekennzeichnet, daß die Bandbreite der Frequenzdurchlaßbereiche der einzelnen Kaskaden gleich ist.

7. Frequenzdetektor nach einem der vorhergehenden Ansprüche mit komplexen Vorentzerrern, für die Einspeisung von jeweils des komplexen Empfangssignals, dadurch gekennzeichnet, daß für beide Nyquistflanken mindestens jeweils zwei Kaskaden vorgesehen sind, deren Mittenfrequenzen und Frequenzdurchlaßbereiche jeweils symmetrisch sich verhalten zu Frequenz f = Null, bzw. zur Mittenfrequenz zwischen den beiden Nyquistflanken im Offsetbereich (Figur 2).

8. Frequenzdetektor nach einem der vorhergehenden Ansprüche, mit Vorentzerrern für reelles Eingangssignal, dadurch gekennzeichnet, daß mindestens zwei Paare von Kaskaden vorgesehen sind, daß die einzelnen Kaskadenpaare jeweils unterschiedliche Mittenfrequenzen, die beiden Kaskaden eines Paares jedoch gleiche Mittenfrequenzen und gleiche Durchlaßbandbreiten aufweisen (Figur 3).

9. Frequenzdetektor nach einem der vorhergehenden Ansprüche, gekennzeichnet durch zwei Kaskaden mit jeweils einer Durchlaßbereichsbandbreite von etwa der halben Nyquistflanke PNyq/2 und mit den Mittenfrequenzen von $|fm|=|fNyq|\pm BNyq/4$ (Figuren 1a, 1b und 1c).

Fig.1

$\phi_Z(f)$  G(f)

Fig.1a

−1/4T          1/4T          f

$B_{Nyq}$

$H_{dp}(f)$

Fig. 1b

−1/4T          1/4T          f

$H_{dn}(f)$

Fig. 1c

−1/4T          1/4T          f

5

FIG. 2

FIG. 3

FIG. 2a

FIG. 3a